Europäisches Patentamt

European Patent Office

Office européen des brevets

(11) Veröffentlichungsnummer: **0 078 335**
**B1**

(12) **EUROPÄISCHE PATENTSCHRIFT**

(45) Veröffentlichungstag der Patentschrift:
05.02.86

(21) Anmeldenummer: 81109368.1

(22) Anmeldetag: 30.10.81

(51) Int. Cl.⁴: **G 11 C 11/40**

④ Verfahren zum Lesen eines Halbleiterspeichers.

(43) Veröffentlichungstag der Anmeldung:
**11.05.83 Patentblatt 83/19**

(45) Bekanntmachung des Hinweises auf die Patenterteilung:
**05.02.86 Patentblatt 86/6**

(84) Benannte Vertragsstaaten:
**DE FR GB**

(56) Entgegenhaltungen:
**EP - A - 0 020 995**
**EP - A - 0 023 538**
**EP - A - 0 031 001**
**EP - A - 0 031 462**

**IBM TECHNICAL DISCLOSURE BULLETIN, Band 22, Nr. 9, Februar 1980, New York, USA, K. HEUBER et al.: "Read/write circuitry"**
**IEEE INTERNATIONAL SOLID STATE CIRCUITS CONFERENCE, 15. Februar 1980, Seiten 222-224, New York, USA S.K. WIEDMANN et al.: "Session XVII: Random access memories"**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB**

(72) Erfinder: **Heuber, Klaus, Taunusstrasse 62, D-7030 Böblingen (DE)**
Erfinder: **Wiedmann, Siegfried, Dr., Im Himmel 64A, D-7000 Stuttgart 80 (DE)**

(74) Vertreter: **Rudolph, Wolfgang, Dipl.-Ing., Schönaicher Strasse 220, D-7030 Böblingen (DE)**

## Beschreibung

Die Erfindung betrifft ein Verfahren zum Lesen eines integrierten Halbleiterspeichers nach dem Oberbegriff des Patentanspruchs 1.

Durch die DE-AS 25 11 518 sind ein Verfahren und eine Schaltungsanordnung zum Betreiben eines integrierten Halbleiterspeichers bekannt geworden, dessen Speicherzellen aus Flip-Flops mit bipolaren Transistoren und Schottky-Dioden als Lese-/Schreib-Ankoppelelemente bestehen und die als Lastelemente hochohmige Widerstände oder als Stromquellen geschaltete Transistoren benutzen, deren Schreib-/Lesezyklen jeweils in mehreren Phasen ablaufen und die durch Pegeländerungen auf Wortleitungen und Bitleitungen selektiert werden, die zum Erhöhen der Schreib- und Lesegeschwindigkeit sowie zum Verringern der Verlustleistung die Entladung der Bitleitungen über die leitenden Speicherzellen-Transistoren vornehmen. Die Entladung der Bitleitung über diese leitenden Speicherzellen-Transistoren erfolgt dabei nach Masse. Während der Lesephase des Speichers werden die Bitleitungen nur geringfügig umgeladen, so daß der Umladestrom, der durch die Speicherzelle fließt, dabei sehr klein ist. In den letzten Jahren hat auf dem Gebiet der logischen Verknüpfungsschaltungen und der integrierten Halbleiterspeichertechnik mit bipolaren Transistoren eine rege Entwicklung stattgefunden, die unter der Bezeichnung MTL (Merged Transistor Logic) oder IIL (Integrated Injection Logic) Eingang in die Fachliteratur gefunden hat. Es wird hierzu auf die Aufsätze im IEEE Journal of Solid State Circuits, Band SC/7, Nr. 5, Okt. 1972, Seiten 340ff verwiesen. Entsprechende Lösungen sind auch in den US-A 37 36 477 und US-A 38 16 748 gemacht worden.

Speicher die mit Speicherzellen aus bipolaren Transistoren aufgebaut sind, die eine MTL-änliche Struktur aufweisen, verlangen zur Selektion einer Speicherzelle die Umladung von Bitdaten- und/oder Steuerleitungskapazitäten. Der Spannungshub der Bitleitungskapazitäten entspricht dabei ungefähr dem Spannungshub der Selektierten Wortleitungen. Wie bereits beschrieben, werden die kapazitiven Entladeströme über die Speicherzellen der selektierten Wortleitung und über den Wortleitungstreiber nach Masse abgeführt. Dies hat jedoch bei einer größeren Anzahl von Speicherzellen innerhalb einer Matrix den Nachteil, daß der Flächenbedarf der Treiberschaltkreise, die elektrische Verlustleistung für jeden Treiber und die Verzögerungszeit bei der Selektion der Wortleitung unverhältnismäßig groß werden, so daß die Vorteile der verwendeten MTL-Struktur wieder zunichtegemacht werden. In der DE-A 29 26 050 ist deshalb ein Verfahren und eine Schaltungsanordnung zum Lesen und Schreiben eines integrierten Halbleiterspeichers bekannt geworden, dessen Speicherzellen aus Flip-Flops mit bipolaren Transistoren in MTL-Technik bestehen, bei dem zu oder während einer Schreibe- bzw. Leseoperation Leitungskapazitäten entladen werden und ein Lese-/Schreibschaltkreis vorhanden ist, wobei der zum Lesen und/oder Schreiben der Speicherzellen erforderliche Strom nur durch die Entladung der Eingangskapazitäten der nicht angesteuerten Speicherzellen erzeugt und direkt den angesteuerten Speicherzellen zum Lesen und/oder Schreiben zugeführt wird. Dabei werden insbesondere die Bitleitungsentladeströme der Bitleitungskapazitäten zum Lesen und/oder Schreiben einer selektierten Speicherzelle benützt. Die Entladeströme aus den Bitleitungs- und Injektor-Sperrschicht-Kapazitäten bei der selektierten Speicherzelle laden Injektor-Diffusions-Kapazitäten und die Entladung dieser Diffusions-Kapazitäten auf der sich im Auszustand befindlichen Seite folgt dabei wesentlich rascher als auf der sich im Einzustand befindlichen Seite, so daß das Lesesignal das Differenzsignal ist, das sich aus dem unterschiedlich raschen Abbau der Ladungen auf der Aus- und Eingangsseite ergibt.

Dieses Leseschema hat jedoch den Nachteil, daß das so gewonnene Lesesignal nicht optimal ist, da die Umladung der Bitleitungs-PNP-Transistoren nicht gesteuert erfolgt.

## Einschub, S. 3

Aus der EP-A- 31 462 und aus der EP-A- 23 538 ist es bekannt, MTL-Speicherzellen in einem Haltleiterspeicher mittels gleicher Ströme auszulesen. Hier wird während zweier Zeitphasen ein Spannungsunterschied zwischen den Bitleitung erzeugt. Obwohl hier bereits während der Zeitphase t2 ausgelesen wird, muß durch das unkontrollierte Umladen lange gewartet werden, bis sich ein abfühlbares Lesesignal durch die Spannungsdifferenzen gebildet hat. Diese Bildung erfolgt unkontrolliert, so daß sowohl die Zeitdauer als auch die Größe des Signals nicht exakt gesteuert werden kann.

Aus der EP-A- 31 001 ist es bekannt, das lesesignal einer MTL- Zelle durch Zurückschaltung der am anfang des Leseverfahrens herabgezogenen Wortleitungspannung zu verstärken.

Der Erfindung liegt deshalb die Aufgabe zugrunde, ein Verfahren zum Lesen eines integrierten MTL-Halbleiterspeichers zu schaffen, dessen SDeicherzellen aus Flip- Flops mit bipolaren Transistoren in MTL Technik bestehen, wo durch das bewußte Ausnutzen von unterschiedlichen effektiven Speicherzeitkonstanten der Transistoren und durch eine gesteuerte Umladung der Bitleitungs-PNP-Transistoren schneller größere Lesesignale erzeugt werden sollen als bei den bisher bekannt gewordenen Verfahren und Anordnungen, die mit zwei Zeitphasen für den Aufbau eines Lesesignals arbeiten.

Die erfindungsgemäße Lösung für das Verfahren ist im kennzeichnenden Teil des Patentanspruchs 1 charakterisiert.

Weitere Verbesserungen ergeben sich aus den Unteransprüchen.

Der Vorteil des erfindungsgemäßen Leseschemas und der dazugehörigen Schaltung besteht darin, daß durch

0 078 335

die gezielte Umladung der Bitleitungs-PNP-Transistoren und durch das gezielte Ausnutzen von unterschiedlichen effektiven Speicherzeitkonstanten ohne besonderen Aufwand an Komponenten in der Schaltung größere und schnellere Lesesignale erzeugt werden können. Außerdem ist ein relativ großer parasitärer Lesestrom der nicht selektierten Speicherzellen zulässig. Die sonst technisch schwierige Restore-Operation ist hier weniger kritisch, obwohl eine geringere Komplexität der gesamten Schaltung vorliegt. Außerdem beeinflussen unterschiedliche Stromverstärkungsparameter der PNP-Transistoren die Leseoperation nicht sehr stark und relativ große Toleranzen der Speicherzelle und der Ansteuerschaltkreise sind möglich, ohne eine sichere Leseoperation zu gefährden. Hinzu kommt noch, daß die erforderliche Ruhestromzuführung und die Schreiboperation auf bekannte Art und Weise erfolgen können. Ein detailliertes Ausführungsbeispiel anhand dessen die Erfindung näher erklärt wird, ist in den Zeichnungen dargestellt.

Es zeigen:

Fig. 1 das Prinzipschaltbild mit einer selektierten Speicherzelle

Fig. 2 den prinzipiellen Zeitverlauf der Ansteuerimpulse für das Leseschema mit gezielter Umladung der PNP-Speicherladungen,;

Fig. 3 ein Impulsdiagramm für eine Zweistufen-Aufladung

Fig. 4 ein weiteres Ausführungsbeispiel einer Schaltung für das Leseschema,;

Fig. 5 ein Ersatzschaltbild einer Speicherzelle zur Erklärung eines Leseschemas mit kapazitivem Bitleitungsstrom und

Fig. 6 ein weiteres Ausführungsbeispiel für das Leseschema nach Fig. 5 mit gleitendem Potential auf der Wortleitung.

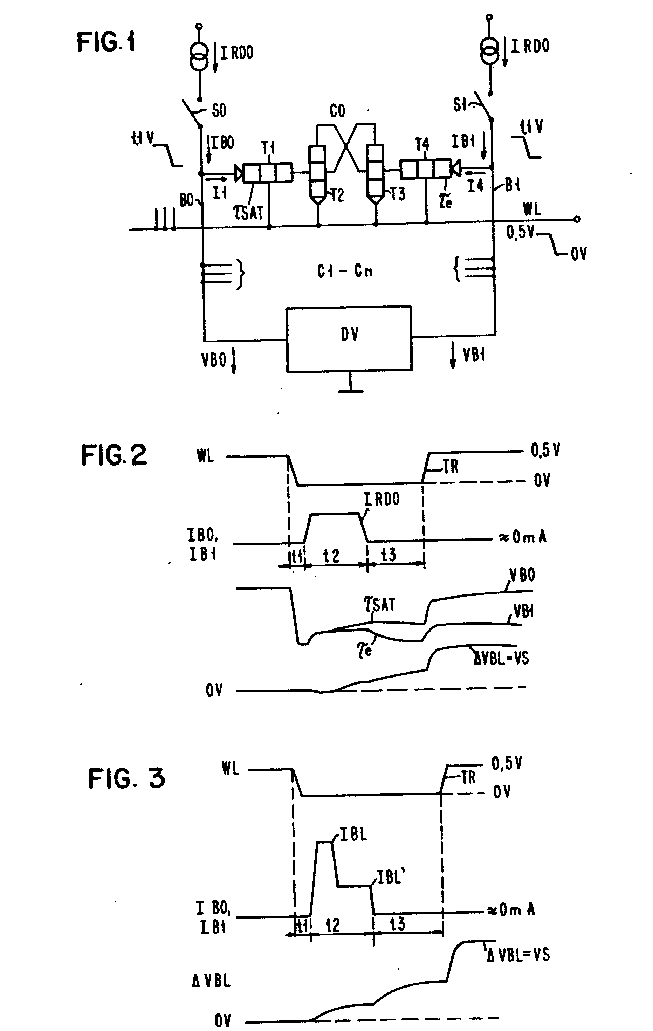

In Fig. 1 ist ein Ausschnitt aus einem MTL-Speicher gezeigt, der in Kreuzungspunkten von Wortleitungen WL und Bitleitungen B0 und B1 angeordnete Speicherzellen C aufweist. In Fig. 1 ist nur eine Wortleitung WL und ein Bitleitungspaar B0, B1 gezeigt. Die Bitleitung B0 ist über einen Schalter S0-mit einer Stromquelle IRD0 verbunden, die Bitleitung B1 über einen Schalter S1 mit einer Stromquelle IRD0 und beide Bitleitungen B0 und B1 sind über einen Differenzverstärker DV abgeschlossen. Zwischen den Schaltern S0, S1 und den Differenzverstärkern sind Speicherzellen C0 bis Cn angeordnet, wovon in der Fig. 1 die Speicherzelle C0 detailliert dargestellt ist und für die Speicherzellen C1 bis Cn sind lediglich die Anschlüsse schematisch gezeigt. Die detailliert gezeigte Speicherzelle C0 besteht aus den PNP-Transistoren T1 und T4, die die beiden kreuzgekoppelten NPN-Transistoren T2 und T3 der Speicherzelle C0 mit den Bitleitungen B0 bzw. B1 verbinden. Die Basiselektrode der PNP-Transistoren TI und T4 und die Emitter der NPN-Transistoren T2 und T3 sind mit der Wortleitung WL verbunden, an der wie schematisch gezeigt, weitere zu einem Wort gehörende Speicherzellen angeschlossen sind.

Bevor die Wirkungsweise des Schaltbildes nach Fig. 1 erklärt wird, soll noch das Impulsdiagramm nach Fig. 2 prinzipiell erklärt werden.

Die oberste Zeile zeigt den Spannungsverlauf auf der Wortleitung, wobei die 0,5 Volt dem Standby-Zustand und die 0 Volt dem selektierten Zustand entsprechen. Darunter ist der Verlauf der Ströme IB0 und IB1 auf den Bitleitungen B0 und B1 gezeigt. Darunter ist der Spannungsverlauf VB0 und VB1, der sich an den Eingängen des Differenzverstärkers DV einstellt, gezeigt und darunter das Differenzsignal $\Delta$VBL.

Für das Impulsdiagramm der Fig. 2 gelten folgende Zeitbedingungen:

$$t1 \leqslant 0$$

$$\tau SAT \gtrsim t2 > \tau e$$

$$\tau SAT > t3 \gtrsim \tau e$$

Die detailliert dargestellte Speicherzelle C0 im Prinzipschaltbild nach Fig. 1 wird in vorliegendem Falle als selektiert angenommen, wobei zu bemerken ist, daß die beiden in das Schaltbild eingezeichneten Spannungsimpulse im oberen Level dem Ruhezustand und im unteren Level dem Lesezustand entsprechen. In bekannter Weise wird die Zelle C0 am Bitleitungspaar B0, B1 durch einen negativen Impuls (eingezeichnet) auf der Wortleitung WL selektiert, wobei wiederum der obere Level dem Ruhezustand im unselektierten Fall entspricht und der untere Level dem selektierten Zustand. Zu bemerken ist noch, daß die Speicherzeitkonstanten der PNP-Transistoren wie folgt vorausgesetzt werden:

$\tau SAT > \tau e$

Gleichzeitig oder mit möglichst geringer Zeitverzögerung t1 (siehe Fig. 2) werden zwei gleiche Stromquellen IRD0 mit Hilfe der Schalter S0 und SI an die Bitleitungen B0 und BI geschaltet, so daß die beiden Injektoren der beiden Bitleitungs-PNP-Transistoren T1 und T4 mit gleichen Strömen versorgt werden. Nach der Zeit t2 (siehe Fig. 2) werden die Stromquellen IRD0 wieder abgeschaltet, wobei die Einschaltzeit so bemessen und gesteuert wird, daß folgende Bedingung erfüllt ist:

$t2 \gg \tau e$.

$\tau e$ ist dabei die Speicherzeitkonstante des PNP-Transistors T4, der mit dem sich im Auszustand befindlichen NPN-Transistor T3 verbunden ist.

3

Die effektive Speicherzeitkonstante τSAT des PNP-Transistors T1, der mit dem eingeschalteten NPN-Transistor T2 verbunden ist, hat wie bereits ausgeführt, einen wesentlich höheren Wert ($\tau SAT \gg \tau e$), da bei gleichem zugeführten Strom der sehr stark gesättigte PNP-Transistor Tl eine beträchtlich höhere Ladung speichert.

Die Ladungsspeicherung im PNP-Transistor T4 beträgt nach der Zeit $t2 \gg \tau e$:

Q4 ~ IRDO - τe.

Der stark gesättigte PNP-Transistor T1 kann jedoch eine wesentlich höhere Ladung, nämlich

Q1 ~ IRDO - τSAT

speichern, falls die Zeitdauer t2 der Stromzufuhr länger ist als die Zeitkonstante τSAT. Für noch längere Zeiten i von t2 nimmt die Ladung Q1 nicht mehr zu. Um nun ein möglichst großes Verhältnis der Speicherladungen Q1 zu Q4 der beiden Transistoren T1 und T4 zu erhalten, muß

t2 ≫ τe

gewählt werden. Andererseits soll aber t2 nicht wesentlich größer als τSAT sein, da nach diesem Zeitpunkt der Ladungsunterschied nicht mehr nennenswert zunimmt.

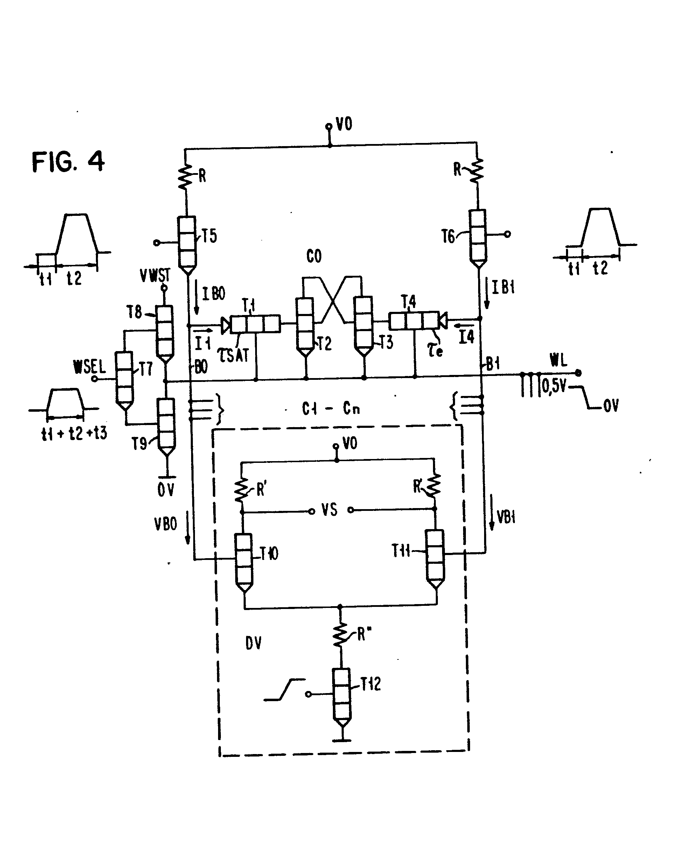

Nun beginnt die zweite Phase des Lesesignalaufbaus. Nach Abschalten der Stromquellen IRDO werden die Speicherladungen Q1 und Q4 wieder abgebaut. Für den Abbau der Speicherladungen Q1 und Q4 sind genauso wie für den Aufbau die zwei unterschiedlichen Zeitkonstanten τe und τSAT maßgebend. Wird die Zeit t3 der Abbauphase größer als τe gewählt, so wird die Ladung Q4 des PNP-Transistors T4 nahezu abgebaut. Die zu Beginn der Abbauphase ohnehin größere Speicherladung Q1 des PNP-Transistors Tl wird aber wesentlich langsamer abgebaut. Bei t2 < τSAT ist der größte Teil der Ladung Q1 des PNP-Transistors noch erhalten. Durch eine solchermaßen gezielt kontrollierte Abbauphase t3 kann man das Verhältnis der restlichen Speicherladungen Q1 zu Q4 wesentlich vergrößern. Wird nämlich unmittelbar nach der Phase t3 die Wortleitungsspannung mit relativ schnellem Anstieg wieder auf den Ausgangswert zurückgebracht (schnelle Rückflanke TR auf der Wortleitung WL in Fig. 2) dann werden die Injektoren der beiden Bitleitungs-PNP-Transistoren Tl und T4 plötzlich ausgeschaltet und die Restspeicherladungen Q1 und Q4 laden die Bitleitungskapazitäten wieder auf. Die Spannungsdifferenz der Bitleitungen, die dem Lesesignal ΔVBL entspricht, ist um so größer, je größer die Restladung Q1 und das Ladungsverhältnis Q1 zu Q4 ist. Durch diesen gezielten, kontrollierten Umladevorgang der Injektoren wird nach relativ kurzer Zeit ein sehr großes Lesesignal ΔVBL erhalten. Die Zeitdauer beträgt hier nur einige Zeitkonstanten τe. Bei den bisher bekannt gewordenen Lesesystemen ist im wesentlichen die wesentlich größere Zeitkonstante τSAT die zeitbestimmende Größe und die Amplitude des Lesesignals ist bedeutend kleiner. Es ist damit klar ein neues Leseschema für MTL-Speicherzellen gezeigt, das eine wesentlich verbesserte Lesegeschwindigkeit gegenüber den bisher bekannt gewordenen Lesesystemen ermöglicht. Darüberhinaus wird auch eine größere Lesespannung erzielt, so daß ein genügend großes Lesesignal auch bei ungünstigen Prozeßparameter-Toleranzen zur Verfügung steht. Das Impulsdiagramm nach Fig. 3 zeigt eine Variante des Leseschemas, das anhand der Fign. 1 und 2 erklärt wurde. Hier wird nämlich eine Zweistufen-Aufladung mit relativ kurzem Spitzenstrom IBL benutzt (siehe mittlere Kurve im Diagramm) um die Zeitdauer für den Aufbau der Speicherladungen abzukürzen. In diesem Diagramm sind wieder der Spannungsverlauf auf der Wortleitung WL, der Stromverlauf auf den Bitleitungen BO und BI sowie der zeitliche Verlauf des Lesesignals ΔVBL = VS gezeigt. In Fig. 4 ist ein detaillierteres Schaltbild für das erfindungsgemäße Leseschema von MTL-Speicherzellen gezeigt. Die Schalter SO und SI sind hier durch die NPN-Transistoren T5 und T6 realisiert. Beide Transistoren T5 und T6 sind mit ihrem Emitter an die Bitleitungen BO bzw. BI angeschlossen, während die Kollektoren jeweils über einen Widerstand R mit einem gemeinsamen Spannungspunkt VO verbunden sind. An der Basis dieser beiden Transistoren T5 und T6 liegt das zum Lesen erforderliche Steuersignal wobei noch die Zeitphasen tl und t2 eingezeichnet sind. Die Wortleitung WL wird von einem Worttreiber gespeist, der aus den Transistoren T7 bis T9 besteht. Am Eingang dieses Worttreibers, der Basis des Transistors T7, liegt der Wortleitungsselektionsimpuls für die Zeitdauer tl + t2 + t3. Der Kollektor ist mit der Basis des Transistors T8 und der Emitter des Transistors T7 ist mit der Basis des Transistors T9 verbunden. Der Kollektor des Transistors T8 liegt an der Spannung für die Wortleitung im Ruhezustand VWST und der Emitter des Transistors T9 liegt auf 0 Volt. Die Verbindung des Emitters des Transistors Tß mit dem Kollektor des Transistors T9 ist an die Wortleitung angeschlossen, an der wiederum eine Anzahl von Zellen entsprechend einem Wort angeschlossen ist.

Der Differenzverstärker wie er als Blockschaltbild in Fig. 1 dargestellt ist, besteht.in der Fig. 4 aus den Transistoren T10 bis T12 und den Widerständen R' sowie R'. Die Basiselektroden der Transistoren TIO und TII sind mit den Bitleitungen verbunden und die Kollektoren dieser beiden Transistoren T10 und T11 sind über jeweils einen Widerstand R' mit einem gemeinsamen Speisepunkt VO verbunden. Über den beiden Kollektoren wird die Ausgangsspannung VS, die dem gelesenen Signal entspricht, abgenommen. Die Emitter der beiden Transistoren T10 und T11 sind gemeinsam über einen Widerstand R' mit dem Kollektor eines Transistors T12 verbunden, dessen Emitter auf Masse liegt und dessen Basiselektrode mit einem Leseimpuls beaufschlagt wird. Die Wirkungsweise dieser Schaltung ist der Schaltung wie sie in Fig. 1 gezeigt ist, entsprecnend, so daß auf eine nochmalige Beschreibung an dieser Stelle verzichtet werden kann. Es soll nur erwähnt werden, daß der Differenzverstärker DV hier einen möglichst hohen Eingangswiderstand aufweisen soll und zwar wenigstens während der gesamten Umladungsphasen t2 und t3.

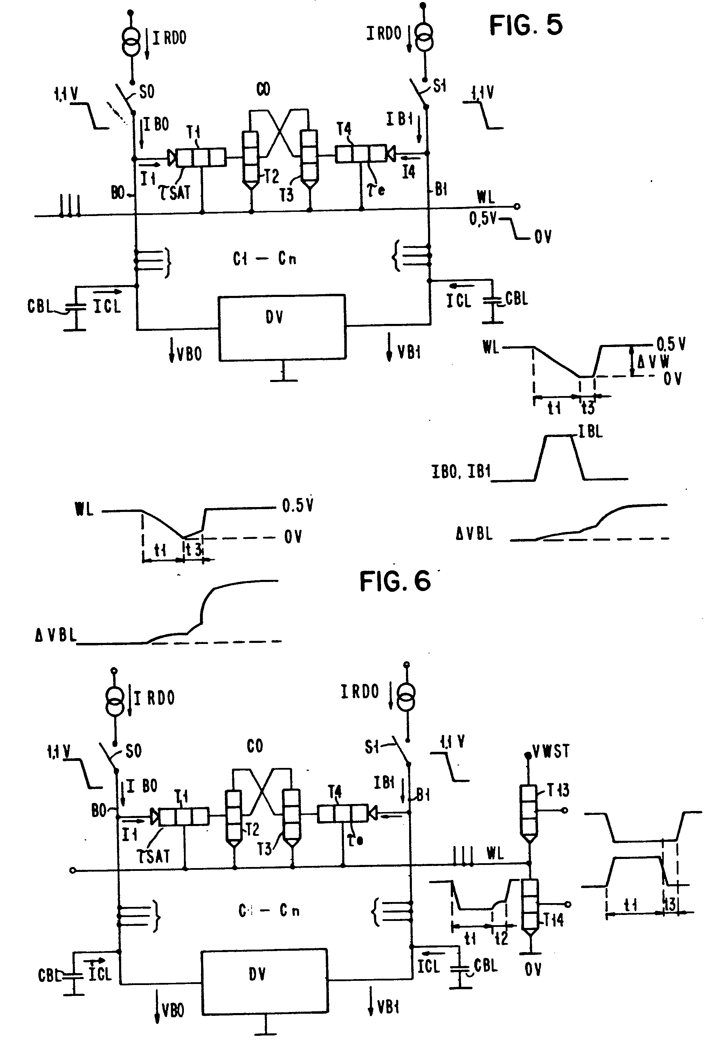

In Fig. 5 ist ein weiteres Ausführungsbeispiel mit Stromund Spannungsverläufen auf den Wortleitungen und auf den Bitleitungen gezeigt. Der Unterschied zu den bisherigen Schaltungen nach den Fign. 1 und 4 besteht darin, daß der Aufladestrom IBO bzw. IB1 aus einer kapazitiven Bitleitungsstromkomponente und/oder einer

4

Gleichstromkomponente bestehen kann. Aus diesem Grunde ist der Bitleitungsstrom IBL gleich IRDO + ICL, wobei die den Strom ICL liefernden Kapazitäten CBL die Bitleitungskapazitäten darstellen. Für diesen Strom gilt:

$$ICL = CBL \cdot \frac{\Delta VW}{t1}.$$

Eine vorteilhafte Ausgestaltung der Schaltung nach Fig. 5 ist in Fig. 6 dargestellt, wobei der Wortleitungstreiber aus den Transistoren T13 und T14 besteht. Die Eingangssignale für die Transistoren T13 und T14 sowie das auf der Wortleitung WL entsprechende Signal innerhalb der Phasen tl bis t3 sind eingezeichnet. Bei dieser Schaltungsanordnung wird für den Fall des kapazitiven Bitleitungsstromes während der Abbauphase t3 die Wortleitung WL nicht auf konstantem Potential gehalten, sondern leitend gelassen. Dadurch wird in kürzerer Zeit ein großes Ladungsverhältnis Q1/q4 der Bitleitungskoppel-Transistoren T1 und T4 erlangt wie aus dem unter dem Schaltbild gezeigten Impulsverlauf für ΔVBL klar hervorgeht.

Im nachfolgenden werden zusammenfassend die Vorteile des Leseschemas und der dazu erforderlichen Schaltung aufgeführt, die darin bestehen, daß

1. ein großes Lesesignal bei höherer Geschwindigkeit als bisher erzielt wird;

2. ein relativ großer parasitärer Lesestrom der nicht selektierten Zellen innerhalb eines Verbands zulässig ist, wodurch die Restore-Operation weniger kritisch wird;

3. unterschiedliche Stromverstärkungsparameter (tracking) der PNP-Transistoren die Leseoperation nicht nachteilig beeinflussen;

4. relativ große Toleranzen sowohl in den Speicherzellen als auch in den Ansteuerschaltkreisen möglich sind, ohne daß die Lesefunktion signalmäßig bzw. geschwindigkeitsmäßig gefährdet wird und

5. daß schnellere und bessere Lesesignale mit einer Schaltung erzielt werden, die eine äußerst geringe Komplexität aufweist.

Erwähnt sei noch, daß die Ruhestromzuführung und die Schreiboperation für den Speicher mit Hilfe der bisher bekannt gewordenen Verfahren ohne weiteres durchgeführt werden können.

## Patentansprüche

1. Verfahren zum Lesen eines integrierten Halbleiterspeichers, dessen ausgeführte Speicherzellen (CO .. Cn) aus FlipFlops mit bipolaren NPN Transistoren (T2, T3) in MTL-Technik und bipolaren PNP Transistoren mit Injektoren (T1, T4) als Bitleitungs-Ankoppeltransistoren bestehen, bei dem vor oder während einer Leseoperation Leitungskapazitäten entladen werden und neben den Wortleitungstreiberhund den Bitleitungstreibern ein Lese-/Schreibschaltkreis vorhanden ist, bei dem gleichzeitig oder mit geringer Zeitverzögerung (tl) mit der Selektion einer Wortleitung (WL) zwei gleiche Stromguellen (IRDO) mit Hilfe zweier jeweils nachgeschalteter Schalter (SO und S1) an die entsprechende Bitleitung (BO und B1) geschaltet werden und die beiden Injektoren der beiden Bitleitungstransistoren (T1, T4) einer Speicherzelle (CO) mit gleichen Strömen versorgt werden, und nach einer zweiten Zeitphase (t2) die Stromquellen (IRDO) wieder abgeschaltet werden, dadurch gekennzeichnet, daß die Dauer der zweiten Zeitphase (t2) wesentlich größer ist als die Speicherzeitkonstante (τe) des Bitleitungstransistors (T4), der mit dem ausgeschalteten Transistor (T3) des Flip-Flops der Zelle (CO) gekoppelt ist, daß die Abbauphase für die Ladungen (Q1 bzw. Q4) der beiden Bitleitungstransistoren (T1 bzw. T4) innerhalb einer dritten Phase (t3) so erfolgt, daß die Ladung (Q4) des Bitleitungstransistors (T4) nahezu abgebaut wird, während die größere Speicherladung (Q1) des anderen Bitleitungstransistors (Tl) entsprechend der unterschiedlichen Zeitkonstanten (τe und τSAT) wesentlich langsamer abgebaut wird, wodurch eine größere Ladungsdifferenz in den Bitleitungsinjektoren entsteht, und daß beim Zurückschalten der Wortleitungen (WL) eine entsprechend große Spannungsdifferenz als Lesesignal auf den Bitleitungen (BO, BI) erzeugt wird.

2. Verfahren nach Anspruch 1, dadurch gekennzeichnet, daß unmittelbar nach der dritten Phase (t3) die Spannung auf der Wortleitung (WL) mit relativ schnellem Anstieg wieder auf den Ausgangspegel gebracht wird, daß die Injektoren der Bitleitungs-PNP-Transistoren (T1 und T4) plötzlich ausgeschaltet werden und die Restspeicherladungen (Q1 und Q4) die Bitleitungskapazitäten (CPL) wieder aufladen, wobei die Spannungsdifferenz der Bitleitungen (BI, BO) um so größer ist, je größer die Restladung (Q1) des einen Bitleitungs-PNP-Transistors (T1) ist.

3. Verfahren nach Anspruch 2, dadurch gekennzeichnet, daß die Aufladung während der zweiten Zeitphase (t2) in zwei Stufen mit relativ kurzem Spitzenstrom (IBL) erfolgt.

4. Verfahren nach Anspruch 2, dadurch gekennzeichnet, daß während der Zeitdauer (t3) der Abbauphase die Wortleitung (WL) nicht auf konstantem Potential, sondern auf gleitendem Potential gehalten wird.

**Claims**

1. A method of reading an integrated semiconductor storage, whose storage cells (CO... Cn) consist of flip-flops in ML technology with bipolar NPN transistors (T2, T3) and bipolar PNP transistors with injectors (T1, T4) as bit line coupling transistors, wherein prior to or during a read operation, line capacities are discharged and in addition to the word line drivers and the bit line drivers, a read/write circuit is provided, wherein simultaneously with the selection of a word line (WL), or with a slight time delay (t1), two identical current sources (IRDO) are connected by means of two switches (SO and S1) to the relevant bit lines (B0 and B1) and the two injectors of the two bit line transistors (T1, T4) of a storage cell (CO) are supplied with the same currents, and after a second time phase (t2), the current sources (IRDO) are switched off, characterized in that the duration of the second time phase (t2) considerably exceeds the storage time constant (τe) of the bit line transistor (T4) coupled to the switched off transistor (T3) of the flip-flop of the cell (CO), that the discharge phase for the charges (Q1 and Q4, respectively) of the two bit line transistors (T1 and T4, respectively) is effected in a third phase (t3) such that the charge (Q4) of the bit line transistor is almost discharged, while the higher storage charge (Q1) of the other bit line transistor (T1) is discharged at a much slower rate according to the different time constants (τe and τSAT), thus generating a greater charge difference in the bit line injectors, and that when the word lines (WL) are switched back, a correspondingly great voltage difference is generated on the bit lines (B0, B1) as a read signal.

2. The method according to claim 1, characterized in that immediately following the third phase (t3), the voltage on the word line (WL) is relatively rapidly returned to the original level, that the injectors of the bit line transistors (T1 and T4) are suddenly switched off and the residual charges (Q1 and Q4) recharge the bit line capacities (CPL), with the voltage difference of the bit lines (B1, B0) being the greater, the higher the residual charge (Q1) of one of the bit line PNP transistors (T1) is.

3. The method according to claim 2, characterized in that charging is effected during the second time phase in two steps at a relatively short peak current (IBL).

4. The method according to claim 2, characterized in that during the time (t3) of the discharge phase, the word line (WL) is not kept at a constant but at a floating potential.


**Revendications**

1. Procédé de lecture d'une mémoire intégrée à semiconducteurs, dont les cellules de mémoire réalisées (C0... Cn) sont constituées par des bascules bistables comportant des transistors NPN bipolaires (T2, T3) selon la technique MTL et des, transistors PNP bipolaires comportant des injecteurs (TI, T4) en tant que transistors d'accouplement des lignes de transmission de bit, et selon lequel avant ou pendant une opération de lecture, des capacités de ligne sont déchargées,et un circuit de lecture/enregistrement est présent à côté des étages d'attaque des lignes de transmission de mots et des étages d'attaque des lignes de transmission de bits, et selon lequel simultanément ou avec un léger retard dans le temps (tl), lors de la sélection d'une ligne de transmission de mots (WL), deux sources de courant identiques (IRDO) sont raccordées à l'aide de deux commutateurs (S0 et S1) branchés respectivement en aval, à la ligne correspondante de transmission de bits (B0 et B1), et les deux injecteurs des deux transistors (TI, T4) des lignes de transmission de bits d'une cellule de mémoire (CO) sont alimentès par des courants identiques, et au bout d'une seconde phase de temps (t2), les sources de courant (IRDO) sont à nouveau débranchées, caractérisé en ce que la durée de la seconde phase (t2) est nettement supérieure à la constante de temps de mémorisation (τe) du transistor (T4) de la ligne de transmission de bits, qui est accouplé au transistor débranché (T3) de la bascule bistable de la cellule (CO), que la phase de suppression des charges (Q1 ou Q4) des deux transistors (TI ou T4) de la ligne de transmission de bits s'effectue pendant une troisiéme phase (t3) de telle sorte que la charge (Q4) des transistors (T4) de la ligne de transmission de bits est approximativement annihilée, tandis que la charge de stockage supérieure (Q1) de l'autre transistor (TI) de la ligne de transmission de bits est annihilée nettement plus lentement conformément aux constantes de temps différents (τe etτSAT), ce qui fait apparaître une différence supérieure de charges dans les injecteurs de la ligne de transmission de bits, et que lors du branchement inverse des lignes de transmission de mots (WL), une différence de tension d'une valeur correspondante est produite en tant que signal de lecture dans la ligne de transmission de,bits (B0, B1).

2. Procédé selon la revendication 1, caractérisé en ce que directement aprés la troisiéme phase (t3), la tension dans la ligne de transmission de mots (WL) est ramenée avec une montée relativement rapide au niveau de sortie , que les injecteurs des transistors PNP (TI et T4) des lignes de transmission de bits sont débranchés brusquement et que les charges de stockage résiduelles (QI et Q4) chargent à nouveau les capacités (CPL) des lignes de transmission de bits, auquel cas la différence de tension des lignes de transmission de bits (B1, B0) est d'autant plus élevée que la charge résiduelle (Q1) d'un transistor PNP (T1) des lignes de transmission de bits est supérieure.

3. Procédé selon la revendication 2, caractérisé en ce que la charge s'effectue pendant la seconde phase de temps (t2) en deux échelons avec un courant maximum (IBL) d'une durée relativement bréve.

4. Procédé selon la revendication 2, caractérise en ce que pendant la durée (t3), de la phase de supression, la ligne de transmission de mots (WL) n'est pas maintenue à un potentiel constant, mais à un potentiel glissant.

FIG.1

FIG.2

FIG. 3

1

FIG. 4

0 078 335

3

0 078 335

FIG. 5

FIG. 6